# EUROPÄISCHE PATENTANMELDUNG

(11) **EP 2 551 680 A2**
(43) Veröffentlichungstag der Anmeldung: **30.01.2013**
(21) Anmeldenummer: 12177457.4
(22) Anmeldetag: 23.07.2012
(51) Int. Cl.: G01R 15/18, G01R 15/20

(54) **Stromsensoranordnung**

(30) Priorität: 28.07.2011 DE 102011080041
(71) Anmelder: Vaccumschmelze Gmbh & Co. KG, 63450 Hanau (DE)
(72) Erfinder: Lenhard, Friedrich, 63452 Hanau (DE); Kudimow, Sebastian, 63456 Hanau (DE)
(74) Vertreter: Patentanwälte Westphal, Mussgnug & Partner

(57) **Zusammenfassung**

Die Erfindung betrifft eine Stromsensoranordnung mit einem Primärleiter zur Leitung eines zu messenden Stromes, mindestens zwei Magnetfeldsonden zur Messung von Magnetfeldern und einem Magnetkern, der eine geschlossene, den Primärleiter umschließende, beliebig ausgeformte Ringstruktur hat, wobei sich in einer vom Magnetkern umschlossenen Magnetkernöffnung eine Primärleiterführung für sowohl rechteckige als auch runde Primärleiter befindet und wobei die Primärleiterführung einen festen Körper mit einer bezüglich der Magnetkernöffnung überlappend angeordneten runden Führungsöffnung und mit einer überlappend angeordneten, über die runde Führungsöffnung hinaus sich erstreckende rechteckige Führungsöffnung aufweist.

## Beschreibung

Die Erfindung betrifft eine Stromsensoranordnung mit einem magnetischen Modul insbesondere zur Verwendung als Kompensationsstromsensor.

Bei der berührungslosen Messung von Strömen werden vornehmlich Stromsensoren eingesetzt, bei denen das Magnetfeld, das von einem durch einen sogenannten Primärleiter fließenden, zu messenden Strom (Primärstrom) erzeugt wird, ausgewertet und daraus der tatsächlich in dem Primärleiter fließende Strom ermittelt wird. Berührungslos arbeitende, d. h. keinen galvanischen Kontakt zum Primärleiter aufweisende Stromsensoren kommen vor allem bei hohen Strömen zum Einsatz.

Stromsensoren können vielfältig ausgestaltet sein, insbesondere im Hinblick auf dort verwendete Magnetfeldsensoren und magnetische Module. Bei den Magnetfeldsensoren handelt es sich hauptsächlich um induktiv arbeitende oder auf dem HallEffekt beruhende Sensortypen. Um das Magnetfeld zu bündeln oder zu leiten, werden weichmagnetische Elemente (z.B. Magnetkern) eingesetzt, die ein Mindestbestandteil eines magnetischen Moduls sind.

Beispielsweise bei sogenannten Kompensationsstromsensoren, bei denen das durch den Primärstrom erzeugte Magnetfeld durch ein von einem Kompensationsstrom bekannter Stärke erzeugtes Magnetfeld zu Null kompensiert wird, kommt als weichmagnetisches Element ein Magnetkern von geschlossener Struktur, wie beispielsweise eine kreisförmige oder rechteckförmige Ringstruktur zum Einsatz, wobei ein Luftspalt zur Aufnahme einer Magnetfeldsonde vorgesehen ist. Mittels der Magnetfeldsonde wird das Restmagnetfeld, das bei nicht vollständiger Kompensation verbleibt, gemessen und der Kompensationsstrom entsprechend nachgeregelt. Der Kampensationsstrom ist dabei ein Maß für den Primärstrom. Insbesondere bei der Messung hoher elektrischer Ströme, beispielsweise oberhalb von 500 A, treten jedoch verschiedene Probleme auf.

Zum Beispiel haben Primärleiter bei hohen Strömen einen entsprechend großen Querschnitt. Bei Kompensationsstromsensoren für hohe Ströme sollte, um die Gesamtabmessungen des magnetischen Moduls möglichst gering zu halten, die Geometrie der den Primärleiter aufnehmenden Innenöffnung des magnetischen Moduls so gewählt werden, dass der freie Raum zwischen magnetischem Modul und Primärleiter möglichst gering ist. Jedoch können die Primärleiter sowohl runde als auch rechteckige Querschnitte aufweisen, so dass die magnetischen Module nur für jeweils einen Primärleiterquerschnitt optimiert werden können und andere Primärleiterquerschnitte nicht oder nur mit Einschränkungen verwendbar sind.

Hat das magnetische Modul beispielsweise eine rechteckige Innenöffnung etwa zur Aufnahme eines bandförmigen Leiters, dann lassen sich in der Regel nur zwei Seiten des Kerns mit Wicklungen versehen, was den möglichen Messbereich einschränkt und die Nichtlinearitäten des Stromsensors erhöht, wodurch wiederum Verfälschungen des Messergebnisses (Messfehler) hervorgerufen werden. Bei Verwendung eines kreisrunden, gleichmäßig bewickelten Ringkernes ist dies kein Problem, jedoch erhöht sich dort der Wickelaufwand und damit der Gesamtpreis erheblich, wobei zudem Messungen an einem Primärleiter mit rechteckförmigem Querschnitt bei gegebenem Ringkern mit runder Innenöffnung nur mit einer verringerten Querschnittsfläche des Leiters und damit mit einem verringerten maximalen Primärstrom durchführbar sind.

Ein anderes Problem besteht darin, dass magnetische Module bei höheren Primärströmen und damit einhergehenden größeren Querschnittsflächen des Primärleiters einen Sensorkern entsprechender Größe benötigen, um den "größeren" Primärleiter durch die Innenöffnung führen zu können. Mit steigendem Primärstrom vergrößern sich zudem die Auswirkungen einer unsymmetrischen magnetischen Aussteuerung des Kerns, wenn beispielsweise die Lage des Stromleiters in der Innenöffnung nicht fest liegt und es dann zu partiellen Sättigungen des magnetischen Moduls kommt. Durch solche Sättigungen können Nichtlinearitäten und damit Messfehler hervorgerufen werden.

Denn selbst wenn bei einem herkömmlichen Kompensationsstromsensor das magnetische Feld im Luftspalt auf im Wesentlichen Null gehalten wird, können an anderen Bereichen des Magnetkerns relativ hohe Magnetfelder auftreten, weil sich dort aufgrund von Streufluss Kompensationsstrom und Primärstrom nicht kompensieren. Dies führt zu hohen Messfehlern, denen man bisher durch hohe Kernquerschnitte entgegenwirkt.

Aufgabe der Erfindung ist es daher, eine Stromsensoranordnung bereitzustellen, die dem gegenüber verbessert ist.

Die Aufgabe wird durch eine Stromsensoranordnung gemäß Patentanspruch 1 gelöst. Ausgestaltungen und Weiterbildungen des Erfindungsgedankens sind Gegenstand von Unteransprüchen.

Die Aufgabe wird insbesondere gelöst durch eine Stromsensoranordnung mit einem Primärleiter zur Leitung eines zu messenden Stromes, mindestens zwei Magnetfeldsonden zur Messung von Magnetfeldern und einem Magnetkern, der eine geschlossene, den Primärleiter umschließende, beliebig ausgeformte Ringstruktur hat, wobei sich in einer vom Magnetkern umschlossenen Magnetkernöffnung eine Primärleiterführung für sowohl rechteckige als auch runde Primärleiter befindet und wobei die Primärleiterführung einen festen Körper mit einer bezüglich der Magnetkernöffnung überlappend angeordneten runden Führungsöffnung und mit einer überlappend angeordneten, über die runde Führungsöffnung hinaus sich erstreckende rechteckige Führungsöffnung aufweist.

Die Erfindung wird nachfolgend anhand der in den Figuren der Zeichnung dargestellten Ausführungsbeispiele näher erläutert, wobei gleiche oder ähnliche Elemente mit denselben Bezugszeichen versehen sind. Es zeigt:
- Figur 1: in einer vereinfachten Skizze einen noch nicht zusammengesetzten zweiteiligen Magnetkern von in zusammengesetztem Zustand annähernd rechteckförmiger Ringstruktur mit einer taschenförmigen Ausnehmung an jeweils einem Ende der beiden Magnetkernteile,
- Figur 2: in einer vereinfachten Skizze einen zusammengesetzten zweiteiligen Magnetkern von annähernd rechteckförmiger Ringstruktur mit an den Fügestellen miteinander korrespondierenden taschenförmigen Ausnehmungen an beiden Enden der beiden Magnetkernteile,
- Figur 3: in einer vereinfachten Skizze einen Abschnitt eines aus Blechlagen gebildeten Magnetkerns mit überlappenden Kernlagen an einer Fügestelle der zwei Magnetkernteile,
- Figur 4: in einer vereinfachten Skizze den Magnetkern nach Figur 3 mit einer Ausnehmung an der Fügestelle sowie mit Blechlagen unterschiedlicher Kernblechtypen,
- Figur 5: in einer vereinfachten Skizze einen zusammengesetzten zweiteiligen Magnetkern mit annähernd rechteckförmiger Ringstruktur und partiellen Überlappungen an den Fügestellen,
- Figur 6: in einer vereinfachten Skizze einen zusammengesetzten zweiteiligen Magnetkern mit annähernd rechteckförmiger Ringstruktur und vollständigen Überlappungen an den Fügestellen,
- Figur 7: in einer vereinfachten Skizze einen zusammengesetzten zweiteiligen Magnetkern mit annähernd rechteckförmiger Ringstruktur, vollständigen Überlappungen an den Fügestellen und im Abstand zu den Fügestellen angeordneten Ausnehmungen,
- Figur 8: in einer schematischen Skizze ein magnetisches Modul mit einem zusammengesetzten zweiteiligen Magnetkern von annähernd rechteckförmiger Ringstruktur, vier Wicklungen sowie einer für rechteckförmige und runde Querschnitte ausgelegten Primarleiterführung,
- Figur 9: in einer Detailansicht eine Fügestelle wie sie bei der Anordnung nach Figur 2 verwendet wird,
- Figur 10: in einer Detailansicht eine Fügestelle gemäß Figur 9 mit abgeschrägter Ecke,
- Figur 11: in einer Detailansicht eine Fügestelle ähnlich der aus Figur 10 mit Überlappungen zwischen den Kernlagen,
- Figur 12: in einer Detailansicht eine Fügestelle, bei der einer der Schenkel eine Verjüngung an der Fügestelle aufweist und Überlappungen zwischen den Kernlagen sowie Abschrägungen an der Außenkante vorgesehen sind,
- Figur 13: in einer Detailansicht eine Fügestelle, bei der beide Schenkel eine Verjüngung an der Fügestelle aufweisen und Überlappungen zwischen den Kernlagen sowie Abschrägungen an der Außenkante vorgesehen sind,
- Figur 14: in einer Detailansicht eine Fügestelle gemäß Figur 1, bei der die Schenkel in entgegengesetzter Folge aneinander gereiht sind und Überlappungen zwischen den Kernlagen sowie Abschrägungen an der Außenkante vorgesehen sind,
- Figur 15: in einer Detailansicht eine Fügestelle gemäß Figur 13 mit anderen Ausgestaltungen der Verjüngungen und des Überlappungsbereichs der Schenkel,
- Figur 16: in einer Detailansicht eine Fügestelle gemäß Figur 13 mit wiederum anderen Ausgestaltungen der Verjüngungen und des Überlappungsbereichs der Schenkel,
- Figur 17: in einer Detailansicht eine Fügestelle gemäß Figur 1 in zusammengesetztem Zustand,
- Figur 18: in einer Detailansicht eine Fügestelle gemäß Figur 6, bei der die Ausnehmung sich nicht in den Überlappungsbereich erstreckt,
- Figur 19: in einer Detailansicht eine Fügestelle mit zwei an den Überlappungsbereich angrenzenden Ausnehmungen,
- Figur 20: in einer Detailansicht eine Fügestelle gemäß Figur 17 mit in den anderen Schenkel verlängerter Ausnehmung,
- Figur 21: in einem Diagramm die gemessene Linearität bei einem Magnetkern ohne Luftspalt für verschiedene Primärleiterpositionen als Stromfehler über dem Primärstrom,
- Figur 22: in einem Diagramm die Linearitäten magnetischer Module mit einer Sonde sowie mit zwei Sonden als Stromfehler über dem Primärstrom und
- Figur 23: in einem Diagramm die Linearität eines Stromsensors mit zwei innen liegenden Tangentialfeldsonden als Stromfehler über dem Primärstrom.

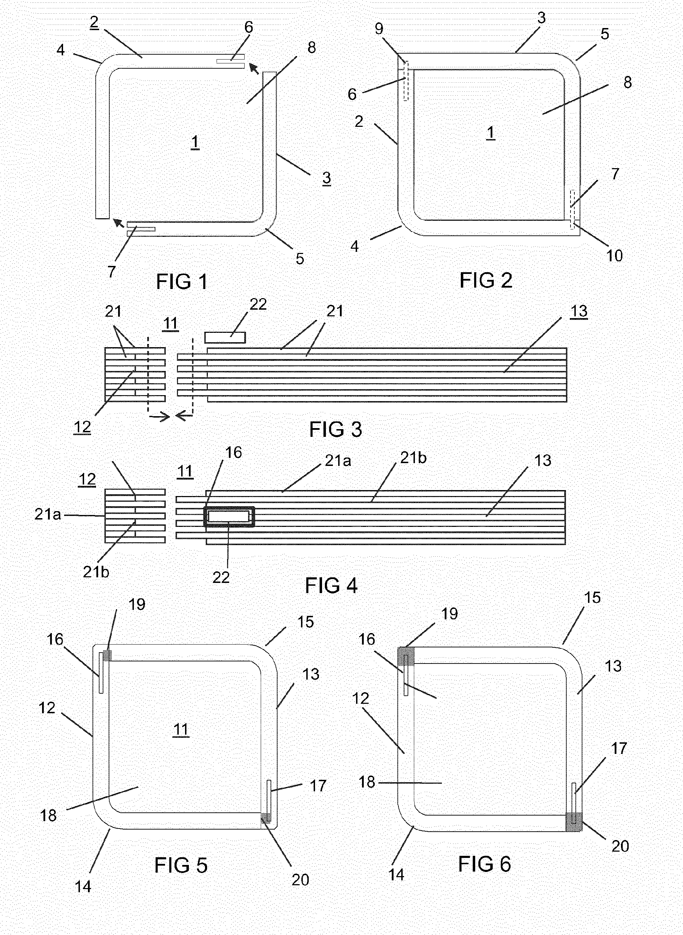

Figur 1 zeigt einen zweiteiligen Magnetkern 1 (beispielsweise zur Verwendung in einem magnetischen Modul eines Stromsensors, insbesondere Kompensationsstromsensors) im noch nicht zusammengesetzten Zustand. Die beiden Teile des Magnetkerns 1 werden dabei durch zwei identisch ausgeführte, L-förmig gekrümmte Schenkel 2 und 3 gebildet, von denen jeder beispielsweise einen rechteckförmigen oder sonstigen geeigneten Kernquerschnitt (nicht gezeigt) aufweist und die Form eines beispielsweise in der Mitte um 90° abgebogenen und demnach Biegungen 4, 5 aufweisenden Stabkerns hat. Die Biegungen 4 und 5 können dabei exakt rechtwinklig mit spitzer Kante oder aber - wie gezeigt - in beliebiger Weise abgerundet oder abgeschrägt ausgeführt sein. An jeweils einer Stirnseite eines solchen Stabes sind in Längsrichtung des Stabes verlaufende Ausnehmungen 6 bzw. 7 vorgesehen, die zur Aufnahme von Magnetfeldsonden vorgesehen sind. Die Ausnehmungen 6 und 7 können dabei so ausgeführt sein, dass sie nach allen Seiten von Kernmaterial umschlossen sind mit Ausnahme einer kleinen Durchführung für Zuleitungen der Magnetfeldsensoren oder zu einer oder zwei Seiten hin offen sind.

Beim Zusammensetzen des Kerns 1 werden dann die beiden Schenkel 2 und 3 so aneinander angeordnet, dass die Stirnseite des die Ausnehmung 6 bzw. 7 aufweisenden Schenkelendes an die seitliche Fläche des Endes des jeweils anderen Schenkels 3 bzw. 2 stumpf anschlägt. Damit wird die Ausnehmung 6 bzw. 7 stirnseitig abgedeckt. Im Falle, dass eine Ausnehmung nur an einer Stelle, der Stirnseite, offen ist, wäre noch auf die Möglichkeit der Zuführung von Leitungen für die Magnetfeldsonde zu achten. Im zusammengebauten Zustand ergibt sich eine Innenöffnung 8 zur Durchführung eines Primärleiters, das weitgehend geschlossen und ringförmig vom Magnetkern 1 umgeben ist. Die Fügestellen zwischen den Schenkeln 2 und 3 bilden dabei Luftspalte, die allerdings eine geringe Spaltbreite, beispielsweise kleiner 0,1 mm, aufweisen. Als Luftspalt wird gemeinhin der Raum zwischen zwei nahe gegenüberliegenden Flächen bezeichnet. Die Spaltbreite ist dabei der Abstand der beiden Flächen in senkrechter Linie voneinander. Die effektive Spaltbreite ist der auf ebene Flächen umgerechnete Abstand von beabstandeten nicht ebenen Gebilden.

Eine Abwandlung des in Figur 1 gezeigten Magnetkerns 1 ist in Figur 2 dargestellt. Dabei setzen sich die Ausnehmungen 6 bzw. 7 in den Schenkeln 2 bzw. 3 in dem jeweils angesetzten anderen Schenkel 3 bzw. 2 fort in Form von Ausnehmungen 9 bzw. 10. Die Ausnehmungen 9 bzw. 10 erstrecken sich somit senkrecht zur Längsrichtung des jeweiligen Schenkelendes im Gegensatz zu den Ausnehmungen 6 und 7, die sich am anderen Schenkelende jeweils in Längsrichtung erstrecken. Die Ausnehmungen 6,7,9, 10 stehen damit senkrecht zu den an den Fügestellen auftretenden Grenzflächen und erlauben das Einbringen von Magnetfeldsonden zur Messung des magnetischen Flusses im jeweiligen Luftspalt ungeachtet dessen geringer Spaltbreite.

Eine andere grundlegende Möglichkeit, die Fügestellen zwischen zwei Schenkeln 12 und 13 eines Magnetkerns 11 auszubilden, zeigt Figur 3. Anders als bei den Ausführungsbeispielen der Figuren 1 und 2 stoßen die beiden Schenkel 12 und 13 an ihren Fügestellen nicht stumpf in der Fläche (ebene Flächen) aufeinander, sondern es sind Überlappungen (nichtebene Flächen) vorgesehen dergestalt, dass - wie gezeigt - beispielsweise in abwechselnder Reihenfolge in einer Richtung (oder in jeder beliebigen Reihenfolge und/oder in eine oder mehrere beliebige andere Richtungen) Bleche eines den Kern bildenden Blechpakets rechtwinklig zu einer die Fügestelle darstellenden, gedachten Grenzfläche (in der Zeichnung strichpunktiert angedeutet) hinweg zurückversetzt sind und das jeweilige Gegenstück, d.h. die entsprechende Blechlage des jeweils anderen Schenkels, über die Grenzfläche hinweg hinausragt. Figur 3 zeigt dabei die Schenkel 12 und 13 im nicht zusammengesetzten Zustand. Die Überlappungen treten erst auf, wenn die Magnetkerne zusammengebaut sind wie etwa durch Zusammenschieben (in der Zeichnung durch Pfeile angedeutet). An den Fügestellen bilden sich räumlich unterschiedlich verlaufende Luftspalten aus, die aufgrund der Überlappungen gegenüber den in den Figuren 1 und 2 gezeigten Magnetkernen noch kleinere effektive Spaltbreiten aufweisen.

Figur 4 betrifft eine Weiterbildung der in Figur 3 dargestellten Anordnung der Schenkel 12 und 13, bei der die Blechlagen aus unterschiedlichen Kernblechtypen, wie zum Beispiel unterschiedlichen Legierungen oder mit unterschiedlichen Stärken, hergestellt sind. Bei diesem Ausführungsbeispiel ist zudem eine Ausnehmung 16 im Schenkel 13 vorgesehen, in der ein Magnetfeldsensor 22 untergebracht werden kann. Der Magnetfeldsensor 22 kann - wie in Figur 3 dargestellt - alternativ nicht in der Ausnehmung, sondern an der Innenseite (Innenwand) des Magnetkerns platziert werden, so dass er sich dann zwischen dem Primärleiter und dem Magnetkern befindet.

Figur 5 zeigt den Magnetkern 11 gemäß Figuren 3 oder 4 in Gänze und im zusammengesetzten Zustand, wobei dieser in seiner Grundstruktur den Magnetkernen 1 der Figuren 1 und 2 ähnlich ist. Der zweiteilig ausgeführte Magnetkern 11 umfasst dabei wie bereits angedeutet die beiden Schenkel 12 und 13, die stabförmig ausgeführt sind und in der Mitte eine Biegung 14 bzw. 15 ergebend rechtwinklig abgebogen sind. Die Biegungen 14 und 15 sind auch beim vorliegenden Magnetkern 11 abgerundet ausgeführt, können aber in jeder anderen geeigneten Form ausgebildet sein wie etwa mit Abflachungen an den Ecken bis hin zum mehr als viereckigen Magnetkern. Wie auch bei den Ausführungsbeispielen nach Figur 1 und Figur 2 stößt die Stirnseite an einem Ende eines Schenkels 12 bzw. 13 auf die Seitenfläche am anderen Ende des jeweils anderen Schenkels 13 bzw. 12. Die Schenkel 12 und 13 weisen an dem Ende, das mit seiner Seitenfläche jeweils an die Stirnfläche des anderen Schenkel stößt, Ausnehmungen 16 bzw. 17 auf, die in Richtung der jeweils anderen Schenkel 13 bzw. 12 hin jedoch nicht geöffnet sind. Die Öffnungen sind im vorliegenden Fall an mindestens einer zu den aufeinander stoßenden Flächen senkrechten Fläche vorgesehen.

Anders als bei den in den Figuren 1 und 2 gezeigten Magnetkernen 1 sind beim Magnetkern 11 nach Figur 5 an den Fügestellen partiell, d.h. in einem Teil des Nahtbereiches (Fügestelle) auch Überlappungen 19 bzw. 20 wie in den Figuren 3 und 4 vorgesehen. Die Überlappungen 19 und 20 erstrecken sich hierbei beispielsweise nur über einen Teil, jedoch nicht über die gesamte Breite der beiden Schenkel 12 und 13. An den verbleibenden Stellen ist die Fügestelle ausgeführt wie bei den Magnetkernen 1 nach den Figuren 1 und 2, d. h. die Stirnseite des einen Endes eines Schenkels schlägt an die seitliche Fläche des Endes des jeweils anderen Schenkels stumpf an. Ausnehmungen 16 und 17 verlaufen in Längsrichtung der Schenkelenden. Eine in den Ausnehmungen 16 und 17 angeordnete (nicht gezeigte) Sonde grenzt somit an die Überlappungen 19 und 20 und damit an die Luftspalte.

Der in Figur 6 gezeigte Magnetkern 11 ist gegenüber dem in Figur 5 gezeigten Magnetkern 11 dahingehend abgeändert, dass nun die Überlappungen 19 und 20 sich über die gesamten Querschnitts-flächen beider Schenkel 12 und 13 unter teilweiser Einbeziehung der Ausnehmungen 16 und 17 erstrecken. Eine darin platzierte Sonde (nicht gezeigt) erfasst somit auch die Überlappungen 19 und 20 und damit die Luftspalte.

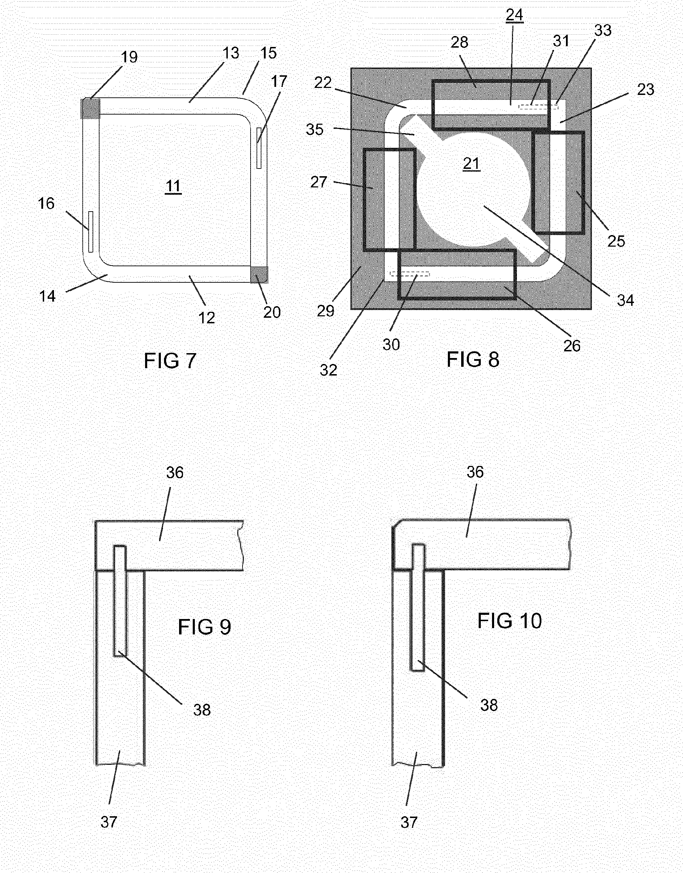

Der in Figur 7 gezeigte Magnetkern 11 ist gegenüber dem Magnetkern 11 nach Figur 6 dahingehend geändert, dass die Ausnehmungen 16 und 17 jeweils von den Fügestellen weg und hin zu den abgerundeten Biegungen 14 bzw. 15 versetzt wurden. Auch beim Magnetkern 11 nach Figur 7 erstrecken sich die Überlappungen 19 und 20 über die gesamte Breite der beiden Schenkel 12 und 13. Die Ausnehmungen grenzen jedoch nicht an die Überlappungen 19 und 20, d. h. nicht an die Luftspalte. Da jedoch die an den Überlappungen 19 und 20 auftretenden effektiven Luftspalte eine äußerst geringe effektive Spaltbreite haben, ist der Fehler durch versetzte, d. h. nicht an oder bei den Luftspalten angeordnete Magnetfeldsensoren ebenfalls gering, da sich der Streufluss an den Luftspalten nur geringfügig von den anderen Bereichen unterscheidet.

Figur 8 zeigt ein magnetisches Modul 21 mit einem aus zwei Schenkeln 22 und 23 zusammengesetzten, also zweiteiligen Magnetkern 24 von annähernd rechteckförmiger Ringstruktur, vier darauf aufgebrachten Wicklungen 25 bis 28 sowie einer für rechteckförmige und runde Querschnitte ausgelegten Primärleiterführung 29. Der Kern 24 weist zudem zwei Ausnehmungen 30 und 31 auf, die jeweils in der Nähe der Fügestellen der beiden Schenkel 22 und 23 angeordnet sind. An den Fügestellen sind auch Überlappungen 32 und 33 (der Übersichtlichkeit halber nicht gezeigt) vorgesehen, die sich über die gesamte Breite der beiden Schenkel 22 und 23 erstrecken und auch teilweise die Ausnehmungen 30 und 31 erfassen. Der Kern 24 entspricht daher im Wesentlichen dem in Figur 6 näher beschriebenen Kern.

Die auf dem Kern 24 angeordneten Wicklungen 25 bis 28 sind dabei so angeordnet, dass sie sich jeweils auf einem der Schenkelabschnitte beiderseits der Biegungen beider Schenkel 22 und 23 (entspricht vier Schenkelabschnitten mit je einer Wicklung) und möglichst nahe an den Fügestellen zwischen den beiden Schenkeln 22 und 23 befinden. Beim vorliegenden Ausführungsbeispiel werden die an den Luftspalten befindlichen Ausnehmungen 30 und 31 weitestmöglich durch die Wicklungen 26 und 28 bedeckt. Die jeweils anderen Wicklungen 25 und 27 stoßen jeweils an die Wicklungen 28 und 26 an. Da sämtliche Wicklungen 25 bis 28 von geringerer Länge sind als die halbe Schenkellänge, d. h. kleiner sind als die Distanz zwischen Biegungsscheitel und Ende des jeweiligen Schenkels (Schenkelabschnitt), verbleibt im Bereich der Biegungen Raum, der nicht von den Wicklungen ausgefüllt wird und somit für die Positionierung von Primärleitern mit rechtförmigem Querschnitt zur Verfügung steht.

Die besondere Anordnung der Wicklungen 25 bis 28 erlaubt es darüber hinaus, einen Primärleiter mit rundem Querschnitt im Innenraum des bewickelten Kerns 24 unterzubringen und zwar derart, dass der verbleibende, vom bewickelten Kern 24 umschlossene Innenraum sowohl für Primärleiter mit rundem Querschnitt als auch mit rechteckigem Querschnitt eine gegenüber einer rein rechteckigen oder runden Auslegung des Querschnitts verbesserte Ausnutzung des Innenraums gewährleistet. Das bedeutet, dass der verbleibende, nicht vom Primärleiter genutzte Innenraum bei Verwendung von Primärleitern mit rechteckigem Querschnitt geringer ist als bei runden Öffnungen und bei Primärleitern mit rundem Querschnitt günstiger ist als bei Öffnungen mit rechteckförmigem Querschnitt. Die Lage eines Primärleiters mit rechteckigem Querschnitt und einem mit rundem Querschnitt ist überlappend wie beispielsweise derart, dass deren Mittelpunkte bzw. Schwerpunkte am selben Punkt zu liegen kommen (co-zentrale Anordnung), wobei die längere Seite des rechteckigen Querschnitts über den runden Querschnitt hinausragt, zum Beispiel diagonal zu den Biegungen.

Um eine stabile Lage des Primärleiters zu gewährleisten unabhängig davon, ob dieser einen runden oder einen rechteckigen Querschnitt aufweist, ist die Primärleiterführung 29 vorgesehen, die die oben beschriebenen Positionen von Primärleitern mit rundem bzw. rechteckförmigem Querschnitt durch entsprechende Öffnungen 34, 35 sicherstellt und damit einer unsymmetrischen Lage des Primärleiters vorbeugt.

Bei dem in Figur 8 gezeigten magnetischen Modul werden durch eine Reihe von Maßnahmen verschiedene beachtliche Vorteile erzielt.

Eine der Maßnahmen sieht vor, dass zwei oder mehrere kleine Luftspalte über den Umfang des ringförmigen Kerns - insbesondere gleichmäßig - verteilt werden. Die (effektive) Breite der Luftspalte liegt jeweils beispielsweise unter 0,1 mm. Die magnetischen Flüsse in den Luftspalten können bei den gezeigten Ausführungsbeispielen durch Magnetfeldsonden, die in den Ausnehmungen 6, 7, 16, 17, 30 und 31 angeordnet sind, ausgewertet werden. Als Magnetfeldsensoren kommen zum Beispiel induktiv arbeitende Sensoren (mit Mikrospulen) oder auf dem Halleffekt beruhende Magnetfeldsensoren in Chipform, die in den Ausnehmungen angeordnet werden, in Frage.

Durch das Verwenden mehrerer "kleiner" Luftspalte lässt sich der mittlere Fluss in vorteilhafter Weise minimieren. Hat man dagegen nur eine Ausnehmung und damit nur eine Magnetfeldsonde, so ist das Feld des Primärleiters an einer Stelle des Magnetkerns zentriert, was dann dazu führen kann, dass an der Magnetfeldsonde das Magnetfeld Null ist und an einer anderen Stelle der Magnetkern nahezu gesättigt ist. Die Verwendung mindestens zweier Sonden wie bei der Erfindung führt dazu, dass an der einen Sonde das Feld die halbe negative Sättigung und die andere Sonde die halbe positive Sättigung erfährt, was im Ergebnis den Gesamtfehler deutlich kleiner hält. Darüber hinaus erlaubt es der gegenüber konventionellen Anordnungen deutlich verringerte mittlere Fluss aufgrund der kleineren Luftspalte und die Verwendung mindestens zweier Magnetfeldsonden, dass den erforderlichen Kernquerschnitt deutlich zu verringern.

Die Verschaltung der Magnetfeldsonden kann dabei unterschiedlich sein. Zum Einen könnte nur ein einziger Regelkreis vorgesehen werden, dem der Mittelwert der Signale aus den einzelnen Magnetfeldsanden zugrundegelegt wird. Zum Anderen könnte jeder Magnetfeldsonde jeweils ein einzelner Regelkreis zugeordnet werden, die dann Gruppen von entsprechenden (Kompensations-) Wicklungen ansteuern. Letztgenanntes Prinzip könnte bei dem in Figur 8 gezeigten magnetischen Modul 21 beispielsweise dadurch realisiert werden, dass eine in Ausnehmung 30 platzierte Magnetfeldsonde und die beiden Wicklungen 26 und 27 einem ersten Regelkreis zugeordnet werden, während eine in Ausnehmung 31 untergebrachte Magnetfeldsonde in Verbindung mit den Wicklungen 25 und 28 einem zweiten Regelkreis zugeordnet werden. Im erstgenannten Fall würde der Mittelwert aus den beiden in den Ausnehmungen 30 und 31 untergebrachten Magnetfeldsonden gebildet, einem einzigen Regelkreis zugeführt, der dann sämtliche Wicklungen 25 bis 28 ansteuert. Welcher der beiden Lösungen der Vorzug gegeben wird oder ob gegebenenfalls Mischformen aus beiden Grundprinzipien verwendet werden, hängt vom jeweiligen Einzelfall ab.

Ein anderer Vorteil der vorliegenden Erfindung ergibt sich daraus, dass Leiter zur Führung hoher Ströme einen ihrem Strom entsprechenden großen Querschnitt aufweisen müssen. Daher ist es notwendig, bei der Erfassung hoher Ströme die Geometrie des Sensorinnenlochs so zu wählen, dass ein Primärleiter mit entsprechendem Querschnitt hindurchgeführt werden kann ohne dabei jedoch den Magnetkern unnötig groß dimensionieren zu müssen. Da bei hohen Strömen anstatt runder Leiter häufig auch Stromschienen mit rechteckförmigem Querschnitt zum Einsatz kommen, sollte das magnetische Modul beide Geometrien zufriedenstellend aufnehmen können. Wählt man ein magnetisches Modul mit bewickeltem runden Ringkern, so ergibt sich durch die Kerngeometrie eine annähernd runde Öffnung der Führung des Primärleiters, die jedoch unter denselben Rahmenbedingungen nicht für die Aufnahme einer Stromschiene mit vergleichbarer Stromtragfähigkeit wie der Primärleiter mit rundem Querschnitt geeignet ist.

In gleicher Weise verhält es sich im umgekehrten Fall, d. h. bei für Stromschienen ausgelegten magnetischen Modulen mit dementsprechend rechteckigen Öffnungen. Diese eignen sich lediglich für Stromschienen, jedoch nicht für runde Leiter. Das in Figur 8 gezeigte magnetische Modul erlaubt es nun, beide Querschnittsvarianten einzusetzen, ohne die extremen Abstriche wie bei den herkömmlichen Ausführungen hinnehmen zu müssen. Dabei kann die in Figur 8 gezeigte Ausführungsform beispielsweise noch stärker an Stromschienen angepasst werden, indem beispielsweise die abgerundeten Biegungen mit größerem Rundungsradien versehen werden oder die Rundungen durch Abschrägungen bzw. Abflachungen versehen werden bis hin zu Mehreckkernen mit einer Eckenzahl größer vier, so dass Stromschienen mit einem geringeren Aspektverhältnis verwendet werden können.

Darüber hinaus sind runde, geschlossene Ringkerne vorteilhaft betreffend die Symmetrie der Bewicklung (zum Beispiel ist eine Vollbewicklung möglich), jedoch nachteilig, im Hinblick auf den Bewicklungsaufwand. Bei für Stromschienen optimierten Magnetkernen können Wicklungen meist nur entlang der beiden längeren Seiten der Stromschiene vorgesehen werden, was zu Unsymmetrien und damit zu Nichtlinearitäten führt. Hier ist jedoch das Bewickeln weniger aufwändig.

Das in Figur 8 gezeigte magnetische Modul bietet auch hier Vorteile, insbesondere bei dessen Herstellung wie etwa der Bewicklung des Magnetkerns. In den Ausführungsbeispielen gezeigte Vieleckkerne bestehen aus mindestens zwei Kernschenkeln, die aus beispielsweise gestanzten Kernblechen zusammengesetzt werden, was einen einfachen und somit kostengünstigen Zusammenbau erlaubt. Die gewählte Form der Schenkel erlaubt die Bestückung aller Seiten des Magnetkerns mit Lagenwicklungen, was sich positiv auf das dynamische Verhalten des Sensors auswirkt, aber im Gegensatz zu beispielsweise geschlossenen Ringkernen ein einfaches Bewickeln zulässt. Schließlich dienen die abgerundeten bzw. abgeflachten Ecken nicht nur einer besseren Anordnung des Primärleiters, sondern erlauben auch eine bessere magnetische Flussführung.

Des Weiteren wird durch die geringe Breite des Luftspalts der Streufluss stark reduziert. Wenn zusätzlich dann über mehrere Sonden über den Umfang verteilt das Magnetfeld gemessen und geregelt wird, kann auch der mittlere magnetische Fluss minimiert werden. Eine Reduzierung der effektiven Spaltbreite auf unter 0,1 mm wird beispielsweise dadurch erreicht, dass der Kern selbst aus mehreren Kernblechlagen aufgebaut ist. Dabei werden an den Fügestellen zwischen den beiden Schenkeln die Lagen um eine gedachte Grenzlinie überlappend ausgebildet, d. h. abwechselnd ragt eine Lage des einen Schenkels und dann die Lage des anderen Schenkels über diese gedachte Grenzlinie hinaus und die entsprechende Lage des anderen Schenkels ist hierbei jeweils verkürzt, wie dies in den Ausführungsbeispielen nach Figur 3 und 4 im Einzelnen gezeigt ist. Damit lassen sich effektive Spaltbreiten von weit unter 0,1 mm erzielen.

Weiterhin kann vorgesehen werden, dass bei den Kernblechlagen des Magnetkerns zwei unterschiedliche Kernblechtypen zum Einsatz kommen. Jede Lage besteht beim fertigen Kern aufgrund der beiden Schenkel aus zwei Kernblechen des gleichen Typs und abwechselnd wird eine Lage des ersten Typs über die Lage des zweiten Typs usw. gestapelt, so dass sich die Stoßstellen jeder Lage abwechselnd an unterschiedlichen Positionen befinden.

Da die Luftspalte sehr klein sind und insbesondere hinsichtlich des Streufeldes kein großer Unterschied mehr zu völlig geschlossenen Kernen besteht, können die Ausnehmungen anstelle an den Fügestellen jedoch auch, wie in Figur 7 gezeigt, an anderen Stellen des Kerns angeordnet werden.

Die Figuren 9 bis 22 zeigen in Detailansicht verschiedene beispielhafte Ausgestaltungen von Fügestellen zweier L-förmiger Schenkel 36 und 37, wobei Ausnehmungen 38, 40 und zum Teil Überlappungen 39 vorgesehen sind. Der Magnetkern kann dabei aus zwei unterschiedlichen L-förmigen Kernblechtypen angefertigt sein. Zwei aneinander gefügte L-förmige Bleche des gleichen Typs bilden jeweils eine Blechlage.

Figur 9 zeigt im Detail eine Fügestelle wie sie bei der Anordnung nach Figur 2 verwendet wird. Die Stirnseite des Schenkels 37 schlägt dabei stumpf an die Längsseite des Schenkels 36 und die Ausnehmung 38 erstreckt sich in beide Schenkel 36, 37.

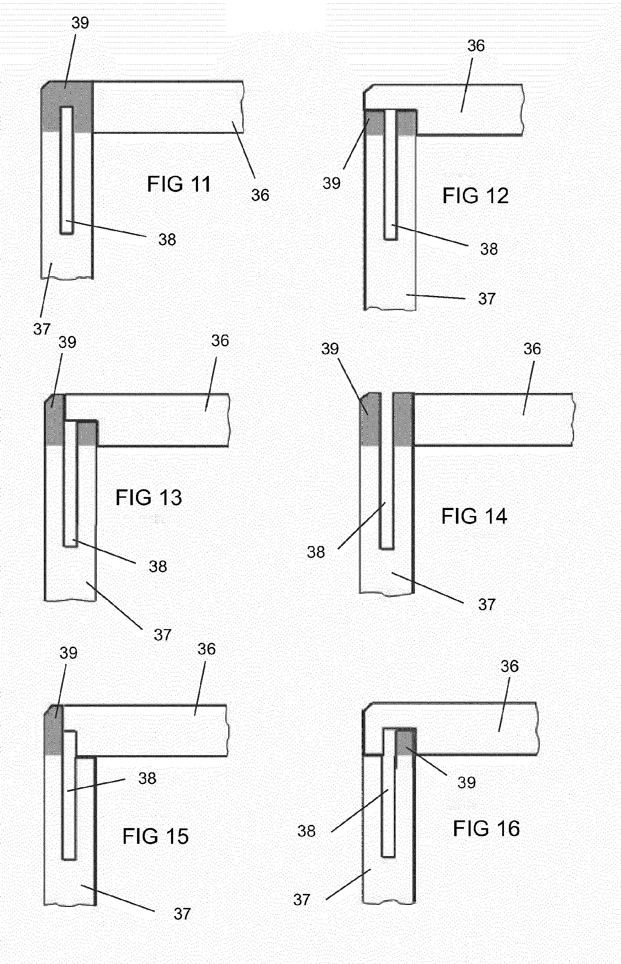

Figur 10 zeigt den Magnetkern aus Figur 9 mit abgeschrägter Ecke bzw. Außenkante. Die abgeschrägte Ecke bzw. Außenkante ist im vorliegenden Fall nur aufgrund der günstigeren Formgebung vorgesehen und nicht wegen eventueller Vorteile im magnetischen Verhalten. Zudem sind bei den in den Figuren 11 bis 19 gezeigten Magnetkernen die Schenkel 36, 37 durch abwechselndes Schichten der Blechlagen an den Fügestellen aneinander gefügt. Die dunkler gezeichneten Flächen zeigen solche Bereiche mit Überlappungen 39. Je größer die Überlappungsfläche ist, desto symmetrischer ist die Feldverteilung im Magnetkern und desto geringer ist die effektive Spaltbreite.

Wie in Figur 11 gezeigt kann eine Fügestelle ähnlich Figur 10 beispielsweise solche Überlappungen 39 zwischen den Kernlagen haben. Die Grundstruktur entspricht dabei im zusammengesetzten Zustand derjenigen aus Figur 10, allerdings ist die Fügestelle anders ausgebildet und zwar derart, dass die Ausnehmung allein in dem Schenkel 38 eingebracht ist und die Fügestelle (Nahtstelle) an der Längsseite des Schenkels 38 sich befindet.

Figur 12 zeigt eine Fügestelle, bei der einer der Schenkel 36 eine Verjüngung an der Fügestelle aufweist. Die Grundstruktur entspricht dabei im zusammengesetzten Zustand derjenigen aus Figur 10, allerdings ist die Fügestelle anders ausgebildet derart, dass die Ausnehmung allein in dem Schenkel 37 eingebracht ist und sich der gesamte Schenkel 37 samt Ausnehmung 38 in eine den Schenkel 36 verjüngende Einbuchtung hinein erstreckt. Die Einbuchtung sorgt dabei für einen stufigen Abschluss des Schenkels 36.

Figur 13 zeigt eine Fügestelle, bei der beide Schenkel 36, 37 jeweils eine Einbuchtung (Verjüngung) an der Fügestelle aufweisen. Dabei hat die "Naht" zwischen den Schenkeln einen mehrstufigen Verlauf.

Figur 14 bezieht sich auf eine Fügestelle gemäß Figur 1, bei der die Schenkel 36, 37 in entgegengesetzter Folge aneinander gereiht sind. Die Ausnehmung 38 ist dabei zur Stirnseite des Schenkels 37 hin offen und der Schenkel 36 stößt stumpf an die Längsseite des Schenkels 37.

In Figur 15 ist eine Fügestelle gemäß Figur 13 dargestellt mit alternativer Ausgestaltung der Verjüngungen und der Überlappungsbereiche der Schenkel 36, 37 derart, dass gegenüber dem in Figur 13 gezeigten Ausführungsbeispiel die Einbuchtung beim Schenkel 36 geringer und diejenige im Schenkel 37 im Volumen größer ausfällt bei dementsprechender Reduzierung des Überlappungsbereiches.

Figur 16 zeigt eine Fügestelle gemäß Figur 13 mit wiederum anderer Ausgestaltung der Verjüngungen und des Überlappungsbereichs 39 der Schenkel 36, 37. Die Verjüngung ist hier als stirnseitig geschlossene Ausnehmung im Schenkel 36 ausgeführt, in die der längere Teil des stufenförmig ausgebildeten Endabschnitts des Schenkels 37 eingreift bei dementsprechender weiterer Reduzierung des Überlappungsbereiches.

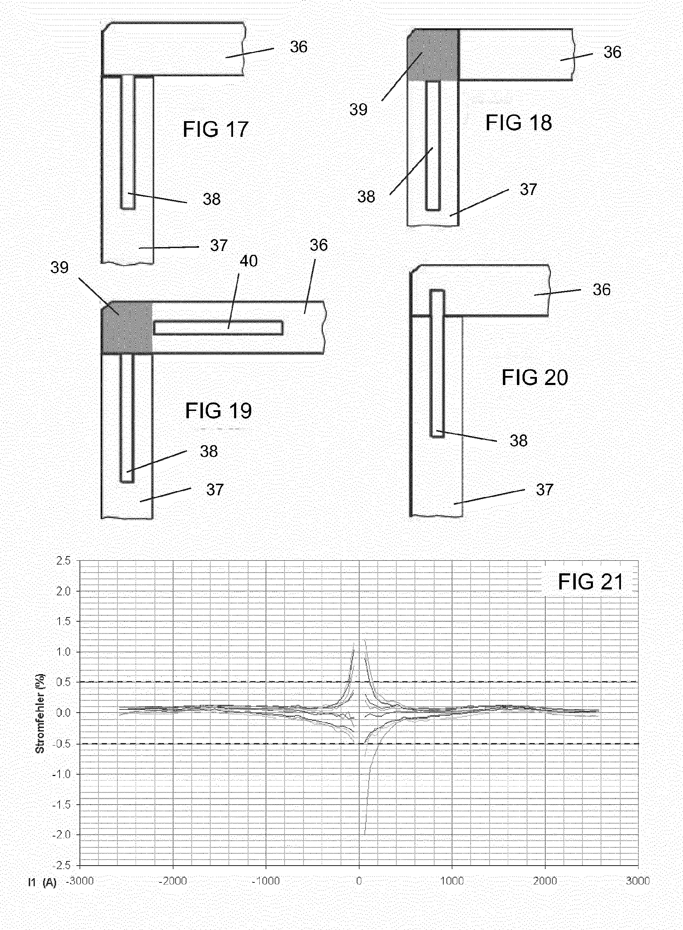

In Figur 17 ist eine Fügestelle gemäß Figur 1 in zusammengesetztem Zustand dargestellt.

Figur 18 zeigt eine Fügestelle gemäß Figur 6, bei der die Ausnehmung 39 sich nicht in die Überlappung 39 hinein erstreckt.

Figur 19 hat eine Fügestelle mit zwei an die Überlappung 39 angrenzenden Ausnehmungen 38, 40 zum Gegenstand.

Figur 20 zeigt eine Fügestelle gemäß Figur 17 mit in den anderen Schenkel verlängerter Ausnehmung.

Figur 21 zeigt den Stromfehler in % in Abhängigkeit vom zu messenden Strom für unterschiedliche Positionen des Primärleiters (Hin- und Rückführung) beim magnetischen Modul nach Figur 8 über dem Primärstrom I1. Wie daraus zu ersehen ist, ist der Stromfehler für höhere Ströme (>500A) sehr gering und annährend linear um 0%, jedenfalls aber deutlich innerhalb eines Fehlerbandes von -0,5% bis +0,5%.

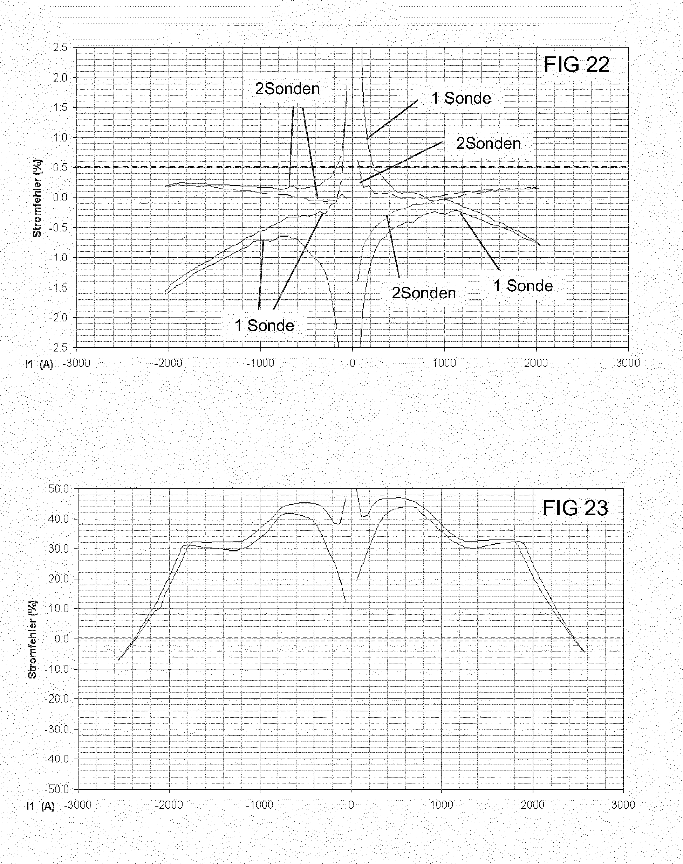

Figur 22 zeigt ebenfalls den Stromfehler in Prozent über dem Primärstrom I1 in Ampere bei Verwendung nur einer Sonde und bei Verwendung von zwei Sonden. Wie zu ersehen ist, ist eine Anordnung mit zwei Magnetfeldsonden deutlich linearer als eine Anordnung mit nur einer Sonde. Zwar hat die Anordnung mit zwei Magnetfeldsonden bereits bei Strömen mit einem Betrag höher 200A einen Stromfehler der betragsmäßig unter 0,5% liegt erreicht, während bei nur einer Magnetfeldsonde der Verlauf an den meisten Stellen außerhalb des Bandes zwischen - 0,5 und + 0,5% Stromfehler liegt.

Figur 23 zeigt die Linearität eines Stromsensors mit zwei innen liegenden Magnetfeldsonden. Die Sonden werden nicht in Magnetkern-Ausnehmungen, sondern an der Innenseite (Innenwand) des Kerns platziert. Diese befinden sich somit zwischen dem Primärleiter und dem Magnetkern. Gemessen wird hierbei das zum Kern tangentiale Magnetfeld.

## Patentansprüche

1. Stromsensoranordnung mit
einem Primärleiter zur Leitung eines zu messenden Stromes,
mindestens zwei Magnetfeldsonden zur Messung von Magnetfeldern und
einem Magnetkern, der eine geschlossene, den Primärleiter umschließende, beliebig ausgeformte Ringstruktur hat, wobei
sich in einer vom Magnetkern umschlossenen Magnetkernöffnung eine Primärleiterführung für sowohl rechteckige als auch runde Primärleiter befindet und wobei
die Primärleiterführung einen festen Körper mit einer bezüglich der Magnetkernöffnung überlappend angeordneten runden Führungsöffnung und mit einer überlappend angeordneten, über die runde Führungsöffnung hinaus sich erstreckende rechteckige Führungsöffnung aufweist.

2. Stromsensoranordnung nach Anspruch 1, bei der der Magnetkern mindestens zwei jeweils eine der Magnetfeldsonden aufnehmenden Ausnehmungen aufweist.

3. Stromsensoranordnung nach Anspruch 1 oder 2, bei der der Magnetkern mindestens zwei aus weichmagnetischem Material geformte, gekrümmte Schenkel aufweist, die jeweils an ihren Enden Fügestellen bildend aneinander gefügt sind.

4. Stromsensoranordnung nach Anspruch 1, 2 oder 3, bei der einem Magnetkern, der eine geschlossene, den Primärleiter umschließende, drei- oder mehreckige Ringstruktur hat, wobei die Magnetfeldsonden an dem Magnetkern oder in Ausnehmungen in dem Magnetkern angeordnet ist.

5. Stromsensoranordnung nach Anspruch 4, bei der der Magnetkern zwei zu einer viereckigen Grundstruktur des Magnetkerns zusammengesetzte L-förmige Schenkel aufweist.

6. Stromsensoranordnung nach Anspruch 4 oder 5, bei der die Schenkel an den Fügestellen Luftspalte bildend stumpf aneinander gefügt sind.

7. Stromsensoranordnung nach Anspruch 4 oder 5, bei der die Schenkel Blechpakete aus gestapelten weichmagnetischen Blechen aufweisen und die Blechpakete zweier Schenkel an den Fügestellen einander überlappend angeordnet sind, wobei je Schenkel ein erster Teil der Bleche bezüglich der Fügestelle überstehend und ein zweiter Teil bezüglich der Fügestelle zurückversetzt angeordnet ist.

8. Stromsensoranordnung nach Anspruch 7, bei der an der Fügestelle durch die sich überlappenden Blechpakete ein Luftspalt mit einer Spaltbreite von 0 bis 0,1 Millimeter ausgebildet ist.

9. Stromsensoranordnung nach Anspruch 7 oder 8, bei dem mindestens zwei Bleche unterschiedliche Legierungen und/oder Blechstärken aufweisen.

10. Stromsensoranordnung nach einem der Ansprüche 3 bis 9, bei der zumindest eine der Ausnehmungen sich über die Fügestellen hinweg in die beiden jeweils aneinander gefügten Schenkel erstreckt.

11. Stromsensoranordnung nach einem der Ansprüche 3 bis 9, bei dem zumindest eine der Ausnehmungen an die Fügestellen angrenzt.

12. Stromsensoranordnung nach einem der Ansprüche 2 bis 11, bei der die zwei der Ausnehmungen des Magnetkerns jeweils an vier, fünf oder sechs Seiten mit magnetischem Material abgeschlossen sind.

13. Stromsensoranordnung nach einem der Ansprüche 1 bis 12, bei der mindestens eine Wicklung auf den Magnetkern aufgebracht ist.

14. Stromsensoranordnung nach Anspruch 13, bei dem zwei L-förmige Schenkel mit jeweils zwei darauf aufgebrachten Wicklungen vorgesehen sind, die jeweils an je einem Ende der Schenkel angeordnet sind und jeweils eine Ausdehnung entlang der Schenkel aufweisen, die kleiner ist als die halbe Länge der L-förmigen Grundstruktur.

15. Stromsensoranardnung nach einem der Ansprüche 1 bis 14, bei der die Magnetfeldsonden in gleichen Abständen entlang des Umfangs des Magnetkerns angeordnet sind.

16. Stromsensoranordnung nach einem der Ansprüche 1 bis 15, bei der die runde und rechteckige Führungsöffnung der Primärleiterführung einander gegenüber und bezüglich der Magnetkernöffnung co-zentrisch angeordnet sind.
